Europäisches Patentamt

European Patent Office

Office européen des brevets

(19)

(11) Publication number: **0 427 091 A1**

# EUROPEAN PATENT APPLICATION

(12)

(21) Application number: 90120788.6

(22) Date of filing: 30.10.90

(51) Int. Cl.⁵: **H01L 27/118**

(30) Priority: 09.11.89 JP 290061/89

(43) Date of publication of application:
15.05.91 Bulletin 91/20

(84) Designated Contracting States:
DE FR GB

(71) Applicant: Kabushiki Kaisha Toshiba
72, Horikawa-cho Saiwai-ku
Kawasaki-shi(JP)

(72) Inventor: Sugoh, Takeshi, c/o Intellectual
Property Division
Kabushiki Kaisha Toshiba, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Input/output circuit in a semiconductor integrated circuit device.

(57) A semiconductor integrated circuit device includ-
ing a bipolar transistor region (6) and a MOS transis-
tor region (5) comprises a semiconductor substrate
(1), a semiconductor integrated circuit (2) formed on
the semiconductor substrate (1), and an input/output
circuit (3), formed on the semiconductor substrate
(1), for inputting/outputting a signal into/from the
semiconductor integrated circuit (2) and an external
circuit. In the input/output circuit (3), the bipolar
transistor region (6) and the MOS transistor region
(5) are arranged separated from each other and
aligned with each other. Hence, the portion in which
the MOS transistor region (5) and the bipolar transis-
tor region (6) are arranged in proximity can be as
small as possible.

FIG. 1

FIG. 2

EP 0 427 091 A1

# INPUT/OUTPUT CIRCUIT IN A SEMICONDUCTOR INTEGRATED CIRCUIT DEVICE

This invention relates to an input/output circuit, formed on a semiconductor chip in a semiconductor integrated circuit device, for inputting/outputting a signal transferred between the semiconductor integrated circuit device and an external electronic circuit, and more particularly to a gate array input/output circuit having a Bi-CMOS (bipolar complementary MOS) structure.

If a parasitic bipolar transistor constituting a thyristor is formed in a MOS transistor region of an input/output circuit of a semiconductor integrated circuit device including MOS transistors and bipolar transistors, a latch-up phenomenon may occur. When this phenomenon occurs, carriers (for example, holes) produced in the semiconductor due to heat or impact ionization turn on the thyristor formed of the parasitic bipolar transistor, thereby allowing a large current to flow between the ground and the power source connected to the semiconductor chip. The latch-up phenomenon may cause a malfunction or even breakage of the semiconductor integrated circuit. Hence, it should be prevented from occurring in a semiconductor integrated circuit.

Further, when the bipolar transistor is arranged near the MOS transistor, a latch-up phenomenon easily occurs in the MOS transistor. This is because the bipolar transistor in the input/output circuit generates a relatively large current, thereby producing carriers which trigger the latch-up phenomenon. Hence, it is desirable that the region be as small as possible, in which the MOS transistor and the bipolar transistor are arranged in proximity.

An object of the present invention is to provide a Bi-CMOS semiconductor integrated circuit having a bipolar transistor and a MOS transistor, in which a latch-up phenomenon is prevented.

To achieve this object, the semiconductor integrated circuit device adapted to an external circuit and including a bipolar transistor region and a MOS transistor region of the present invention comprises a semiconductor substrate, a semiconductor integrated circuit formed on the semiconductor substrate, and an input/output circuit means for performing input/output operation of a signal to be transferred between the semiconductor integrated circuit and the external circuit, the input/output circuit means including the bipolar transistor region and the MOS transistor region, which are arranged on the semiconductor substrate and separated from and adjacent to each other.

According to the present invention, the bipolar transistor region and the MOS transistor regions are separated from each other and aligned with each other, thereby easily preventing a latch-up phenomenon. Moreover, when the input/output circuit has a gate-array structure, regular interconnection is achieved with simple design.

This invention can be more fully understood from the following detailed description when taken in conjunction with the accompanying drawings, in which:

Fig. 1 is a plan view showing the arrangement of a gate array semiconductor integrated circuit on a substrate;

Fig. 2 is a diagram schematically showing the arrangement of the input/output circuit according to a first embodiment of the present invention;

Fig. 3 is a diagram schematically showing BiCMOs inverter circuit; and

Fig. 4 is a diagram schematically showing the arrangement of the input/output circuit according to a second embodiment of the present invention.

Embodiments of the present invention will now be described with reference to the accompanying drawings.

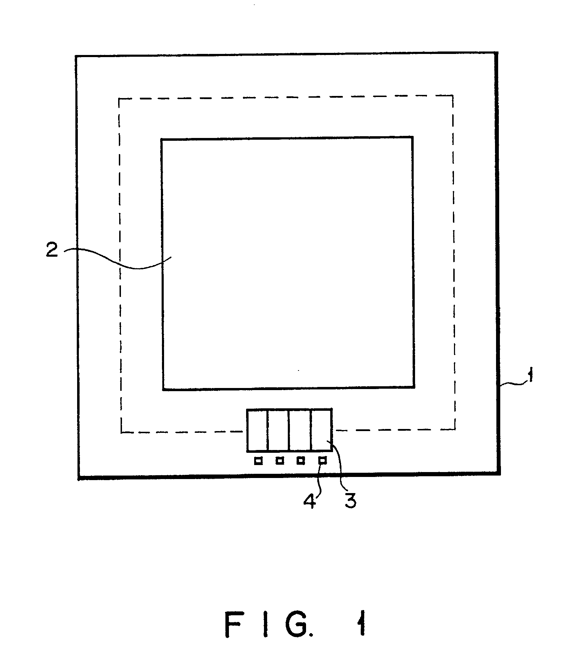

Fig. 1 show a semiconductor integrated circuit device comprising semiconductor substrate 1 and semiconductor integrated circuit 2 (e.g., internal cells of a gate array) formed thereon. Semiconductor integrated circuit 2 fulfills major functions of the semiconductor integrated circuit device. The device also comprises I/O cell sections (input/output circuits) 3, indicated by the solid lines and broken lines in Fig. 1, which performs signal input/output operations between the integrated circuit and an external electronic circuit, and input/output pads 4 (made of aluminum, in general) for I/O sell sections 3. Further, the device includes a package (not shown) for housing the above-mentioned elements and lead lines (not shown) for connecting input/output circuits 3 to an external electronic circuit. The input/output circuit also has a gate array structure.

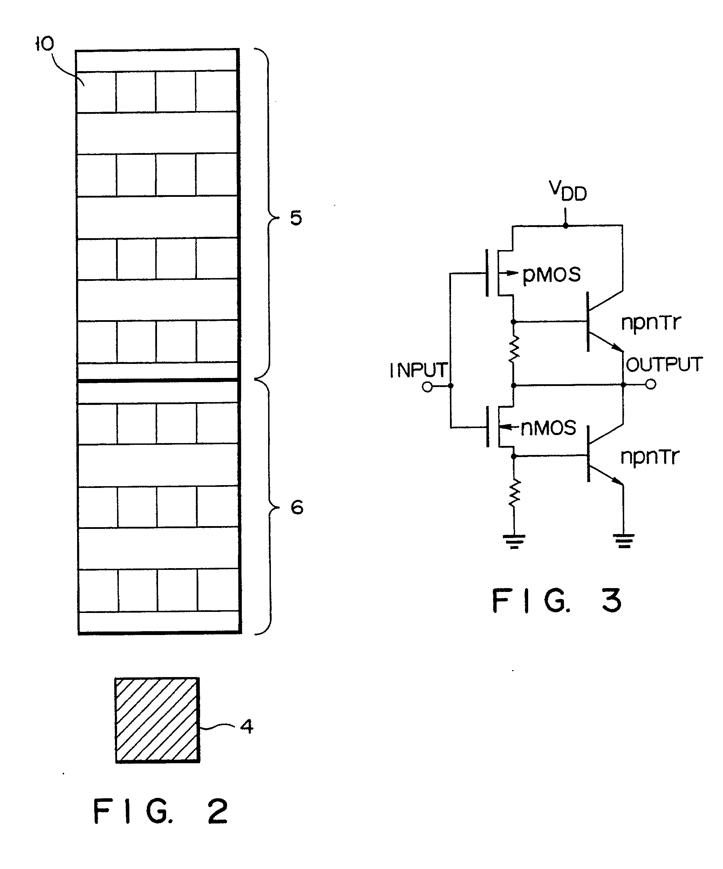

Fig. 2 is an enlarged view showing I/O cell section 3 and input/output pad 4 shown in Fig. 1. In a gate array, a number of columns of basic cells or elements 10 for constituting basic logical circuits (gates), such as NAND, NOR, or INVERTER circuit, are arranged regularly. These elements 10 are interconnected to one another in a wiring step in accordance with the respective design required by users. In Fig. 2, reference numeral 5 denotes a MOS transistor region and reference numeral 6 denotes a bipolar transistor region. Thus, the input/output circuit according to the invention comprises a BiCMOS which includes a bipolar transistor and a MOS transistor. An inverter circuit is shown in Fig. 3 as an example of the BiCMOS circuit. Again in Fig. 2, the MOS transistor region and the bipolar transistor region include not only a MOS transistor and a bipolar transistor, respectively, but also various circuit elements (for example, a diffusion resistor). MOS transistor region 5 and bipolar transistor region 6 are definitely separated from each other.

In the structure of Fig. 2, since the portion in which MOS transistor region 5 and bipolar transistor region 6 are arranged in proximity can be as small as possible, a latch-up phenomenon scarcely occurs in the MOS transistor region.

Moreover, bipolar transistor region 6 which generates a relatively large current is arranged nearer to input/output pad 4. Hence, the aluminum wire connecting the output of a bipolar transistor and pad 4 can be short. As a result, the large current as noise affects little the circuits arranged near the aluminum wire, and the patterning design is simple.

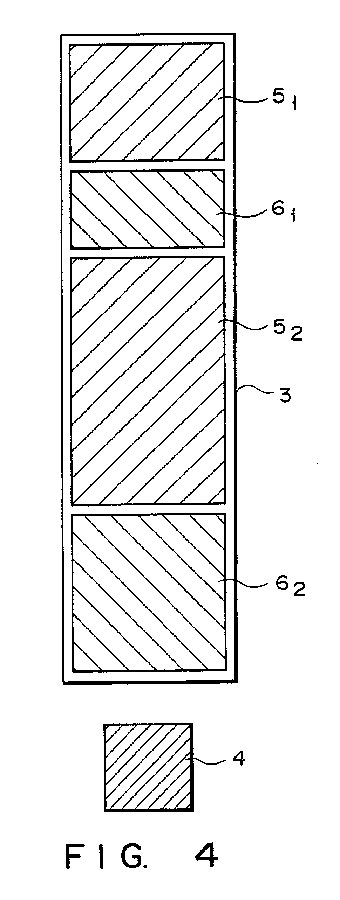

Fig. 4 shows a second embodiment of the input/output circuit according to the present invention, which comprises a plurality of MOS transistor regions and bipolar transistor regions. In the structure of Fig. 4, MOS transistor region $5_1$, bipolar transistor region $6_1$, MOS transistor region $5_2$, and bipolar transistor region $6_2$ are separated from and aligned with one another. Bipolar transistor region $6_2$ includes a bipolar transistor which generates a relatively large current. Hence, the bipolar transistor can be positioned far from those portions of MOS transistor regions $5_1$ and $5_2$ in which a latch-up phenomenon is easy to occur, thereby preventing a latch-up phenomenon. In addition, when the input/output circuit is constituted by a gate array, since the above-mentioned regions are aligned with one another, regular interconnection can be achieved with simple patterning. Also in this embodiment, the region nearest to the input/output pad 4 is the bipolar transistor region, resulting in the same effect as in the first embodiment.

Reference signs in the claims are intended for better understanding and shall not limit the scope.

## Claims

1. A semiconductor integrated circuit device adapted to an external circuit and including a bipolar transistor region (6) and a MOS transistor region (5) comprising:
a semiconductor substrate (1);
a semiconductor integrated circuit (2) formed on said semiconductor substrate (1); and
an input/output circuit means (3) for performing input/output operation of a signal to be transferred between said semiconductor integrated circuit (2) and said external circuit, said input/output circuit means (3) including the bipolar transistor region (6) and the MOS transistor region (5), which are arranged on said semiconductor substrate (1) and separated from and adjacent to each other.

2. A semiconductor integrated circuit device according to claim 1, characterized in that said input/output circuit (3) has a gate array structure.

3. A semiconductor integrated circuit device according to claim 2, characterized in that said semiconductor integrated circuit (2) has a gate array structure.

4. A semiconductor integrated circuit device according to claim 1, characterized in that said input/output circuit (3) further includes at least one additional bipolar transistor region ($6_2$) and at least one additional MOS transistor region ($5_2$).

5. A semiconductor integrated circuit device according to claim 1 or 4, characterized in that said input/output circuit (3) comprises an input/output pad (4), and the region nearest to said input/output pad (4) is said bipolar transistor region ($6_2$).

6. A semiconductor integrated circuit device according to claim 1, characterized in that said bipolar transistor region (6) and MOS transistor region (5) are aligned with each other.

# F I G. 1

FIG. 2

FIG. 3

$5_1$

$6_1$

$5_2$

$3$

$6_2$

$4$

F I G. 4

# EUROPEAN SEARCH REPORT

## EP 90 12 0788

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 12, no. 314 (E-649)[3161], 25th August 1988, Tokyo, JP; & JP-A-63 080 559 (FUJI ELECTRIC CO., LTD) 11-04-1988 * Abstract; figures * | 1 | H 01 L 27/118 |
| A | US-A-4 591 894 (TOKYO SHIBAURA DENKI K.K.) * Column 2, lines 26-68; claim 1; figures 2-3 * | 1,3,6 | |
| A | HITACHI REVIEW, vol. 38, no. 1, February 1989, pages 55-58, Tokyo, JP; S. KADONO et al.: "Superhigh-speed Bi-CMOS gate array "HG29M100/HG21T30" * Page 57: "Input/output buffers"; page 56, figure 3 * | 1-3 | |
|  |  |  | TECHNICAL FIELDS SEARCHED (Int. Cl.5) |
|  |  |  | H 01 L 27 |

The present search report has been drawn up for all claims

| Place of search | Date of completion of search | Examiner |
|---|---|---|
| The Hague | 05 December 90 | FRANSEN L.J.L. |